# EUROPEAN PATENT SPECIFICATION

(11) **EP 4 322 410 B1**
(45) Date of publication and mention of the grant of the patent: **01.04.2026**
(21) Application number: 23188080.8
(22) Date of filing: 27.07.2023
(51) Int. Cl.: H03K 17/975

(54) **MICROELECTROMECHANICAL BUTTON DEVICE AND CORRESPONDING WATERPROOF USER INTERFACE ELEMENT**
MIKROELEKTROMECHANISCHE KNOPFVORRICHTUNG UND ENTSPRECHENDES WASSERDICHTES BENUTZERSCHNITTSTELLENELEMENT
DISPOSITIF DE BOUTON MICROÉLECTROMÉCANIQUE ET ÉLÉMENT D'INTERFACE UTILISATEUR ÉTANCHE À L'EAU CORRESPONDANT

(30) Priority: 10.08.2022 IT 202200017097
(43) Date of publication of application: 14.02.2024
(73) Proprietor: STMicroelectronics S.r.l., 20864 Agrate Brianza (MB) (IT)
(72) Inventor: VERCESI, Federico, 20134 MILANO (IT); GATTERE, Gabriele, 21040 CASTRONNO (VA) (IT); ALLEGATO, Giorgio, 20900 MONZA (MB) (IT); AZPEITIA URQUIA, Mikel, 20128 MILANO (IT); DANEI, Alessandro, 20822 SEVESO (MB) (IT)
(74) Representative: Studio Torta S.p.A.

(56) References cited:
- EP-A1- 3 799 311
- US-A1- 2010 300 862

## Description

The present solution relates to a microelectromechanical button device (made in MEMS - Micro-Electro-Mechanical System - technology) and to a corresponding waterproof (resistant to water or, in general, to liquids) user interface element, in particular for a portable or wearable electronic apparatus.

The need is known, for example in the field of portable electronic apparatuses (such as smartphones or tablets) or wearable electronic apparatuses (such as smartwatches or electronic bracelets), to provide user interface elements including physical buttons (i.e., not provided via touch-screen technology) and meeting requisites of impermeability so as to enable use of the same portable or wearable electronic apparatuses even in the presence of moisture, water, or other kinds of liquids.

In general, provision of such user interface elements is particularly complex, with dedicated assembly systems, for example including hermetic gaskets, so-called O-rings, or similar elements designed to guarantee water tightness in the coupling with an outer case or housing of the aforesaid portable or wearable electronic apparatuses and thus prevent penetration of water or other liquids into the same housing.

For instance, US 2015/0092345 A1 discloses a sealed physical button for use in a portable electronic apparatus, in particular a smartphone. This button includes a cap having a portion external to the housing of the electronic apparatus and having flange portions that interlock, inside the housing, with complementary flanges of a retainer element of a button element. The cap further comprises a downward oriented central post, proportioned and oriented to interface with the top surface of the button element. The retainer element of the button has an aperture sized and positioned for receiving the central post of the cap and rests on a shelf within the housing so as to create a sealed coupling.

Solutions of such a kind, in addition to being complex to implement, are typically subject to problems of wear and damage over time and due to the associated ageing of materials.

Other proposed solutions (see, for example, US 2013/187742 A1) envisage use of inductive elements (for example, in the form of coils) arranged within the housing of the portable or wearable electronic apparatus, at a distance from a portion of the same housing, the pressure of a user on the aforesaid portion causing a detectable variation of an inductance value of the inductive elements.

Not even the above solutions are exempt from defects, for example due to an associated energy consumption and to a general difficulty of implementation, in particular on account of the reduced dimensions available for providing the physical buttons (and the associated inductive elements) in the aforesaid portable or wearable electronic apparatuses.

US 2010/300862 A1 discloses a touch sensor, which can be formed over a substrate, where a display portion is also provided. The touch sensor includes a microstructure in which a pair of electrodes facing each other is isolated with an insulating material. As the insulating material, an elastic material or a material having a hole is used so that a filler layer formed using the insulating material can be deformed when a movable portion operates.

The aim of the present invention is in general to provide a solution that will enable the problems previously highlighted to be overcome.

According to the present invention a microelectromechanical button device and a corresponding user interface element for an electronic apparatus, of a portable or wearable type, are provided as defined in the appended claims.

For a better understanding of the present invention, preferred embodiments thereof are now described, purely by way of non-limiting example, with reference to the attached drawings, wherein:
- Figure 1 is a schematic cross-sectional illustration of a portable or wearable electronic apparatus having a case that houses a microelectromechanical button device;
- Figure 2 is a schematic representation of the deformation of a deformable portion of the case of the electronic apparatus, to which the microelectromechanical button device is coupled;
- Figure 3 is a schematic cross-sectional view of the microelectromechanical button device coupled to an inner surface of the case of the portable electronic apparatus;
- Figure 4A is a more detailed schematic cross-sectional view of a detection structure of the microelectromechanical button device, according to an embodiment of the present solution;
- Figure 4B is a schematic top view of part of the detection structure of Figure 4A;
- Figures 5A-5G are cross-sectional views of the microelectromechanical structure of Figure 4A, in successive steps of a corresponding manufacturing process;
- Figure 6A is a schematic cross-sectional view of a detection structure of the microelectromechanical button device, according to a further embodiment;
- Figure 6B is a schematic top view of the detection structure of Figure 6A;
- Figures 7A-7F are cross-sectional views of the microelectromechanical structure of Figure 6A, in successive steps of a corresponding manufacturing process; and
- Figure 8 is a schematic cross-sectional view of a variant embodiment of the detection structure of the microelectromechanical button device.

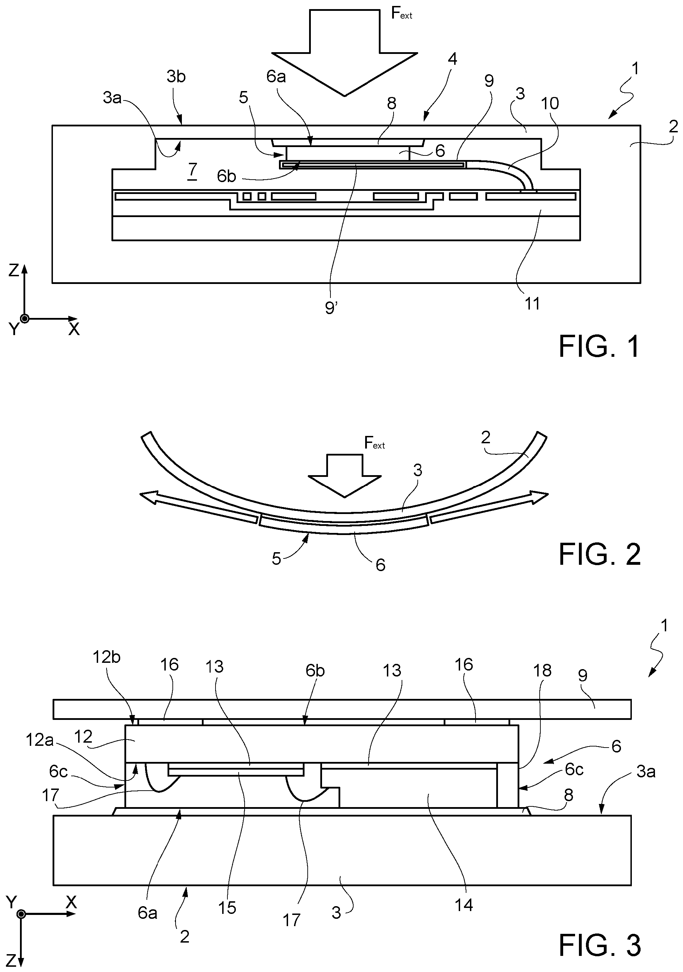

Figure 1 is a schematic cross-sectional view of a portion of an electronic apparatus 1 of a portable type, for example a smartphone, or of a wearable type, for example a smartwatch.

The electronic apparatus 1 is provided with a case 2, which has a deformable portion 3, which is designed to form part of a user interface element 4, in particular defining a physical button.

The aforesaid deformable portion 3 is provided, for example, by thinning (as illustrated in Figure 1), or other appropriate machining operation, of the aforesaid case 2 so as to define a membrane portion.

According to an aspect of the present solution, the user interface element 4 comprises, in a chamber 7 arranged within the case 2, a microelectromechanical (MEMS) button device 5, having a package 6 coupled to the aforesaid deformable portion 3.

In particular, the package 6 has a first main surface (for example, a top surface) 6a, which extends in a horizontal plane xy and is coupled to an inner surface 3a of the deformable portion 3 facing the chamber 7 inside the case 2, being fixed to the same deformable portion 3, for example by means of an adhesive layer 8 of glue or DAF (Die-Attach Film).

The package 6 further has a second main surface (in the example, a bottom surface) 6b, opposite to the first main surface 6a along a vertical axis z orthogonal to the horizontal plane xy. This second main surface 6b is coupled, inside the aforesaid chamber 7, to a flexible support 9 (for example, a PCB - Printed Circuit Board - of a flexible type.

The above flexible support 9, which integrates appropriate electrical-connection paths 9' (represented schematically), is in turn electrically connected, by a suitable connection element 10 (for example, including electrical wires and/or an appropriate electrical connector), to a printed circuit board 11, housed within the chamber 7 and fixed to the case 2, to which further circuit elements or components of the aforesaid electronic apparatus 1 may be connected (in a per se evident manner, here not described in detail). Conveniently, also this printed circuit board 11 may be made of flexible material.

As represented schematically also in Figure 2, during operation, a pressure (or external force Fₑₓₜ) exerted by the user on the aforesaid deformable portion 3 of the case 2 causes deformation thereof (in particular, bending or deflection towards the chamber 7), which in turn causes a deformation of the package 6 of the microelectromechanical button device 5, fixedly coupled to the same deformable portion 3.

As will be described in detail hereinafter, the deformation experienced by the package 6 of the microelectromechanical button device 5 causes a variation of an electrical output signal supplied by the same microelectromechanical button device 5, this variation in particular being indicative of the state, either open or closed (or likewise pressed or not pressed), of the microelectromechanical button device 5, or, in other words, of the actuation of the same microelectromechanical button device 5.

In particular, according to an embodiment (which will be described in detail), the aforesaid deformation causes a capacitive variation in a detection structure of the microelectromechanical button device 5.

Advantageously, the aforesaid user interface element 4 is intrinsically hermetic, the microelectromechanical button device 5 being in fact arranged within the chamber 7 formed in the case 2 of the electronic apparatus 1, without any access towards the environment external to the electronic apparatus 1.

In greater detail, and with reference to Figure 3, in a possible embodiment, the package 6 of the microelectromechanical button device 5 is of the so-called wafer-level-package type.

The package 6 comprises a base or supporting layer 12, having a front surface 12a; the detection structure, here designated by 14, and an associated electronic circuit 15, of an ASIC (Application-Specific Integrated Circuit) type, provided in respective dies of semiconductor material, are coupled to this supporting layer 12 alongside one another, in particular by means of a respective coupling layer 13.

The supporting layer 12 further has a rear surface 12b, vertically opposite to the front surface 12a, which defines the second main surface 6b of the package 6, which is to be coupled to the flexible support 9, by appropriate electrical-connection elements 16, such as pads, as in the example illustrated in the aforesaid Figure 3, or conductive bumps.

Electrical wires 17 electrically connect together the detection structure 14 and the associated electronic circuit 15 (in particular, connecting together corresponding contact pads, here not illustrated, carried by a corresponding surface, opposite to the surface of coupling to the supporting layer 12), and also the same electronic circuit 15 to through connection elements (not illustrated) that traverse the supporting layer 12 and reach the electrical-connection elements 16.

A coating 18, for example of epoxy resin, covers and laterally coats the detection structure 14 and the associated electronic circuit 15, further defining part of lateral outer surfaces 6c and of the first main surface 6a of the package 6 (part of the first main surface 6a itself being defined by the surface of the die of the detection structure 14, opposite to the surface of coupling to the supporting layer 12).

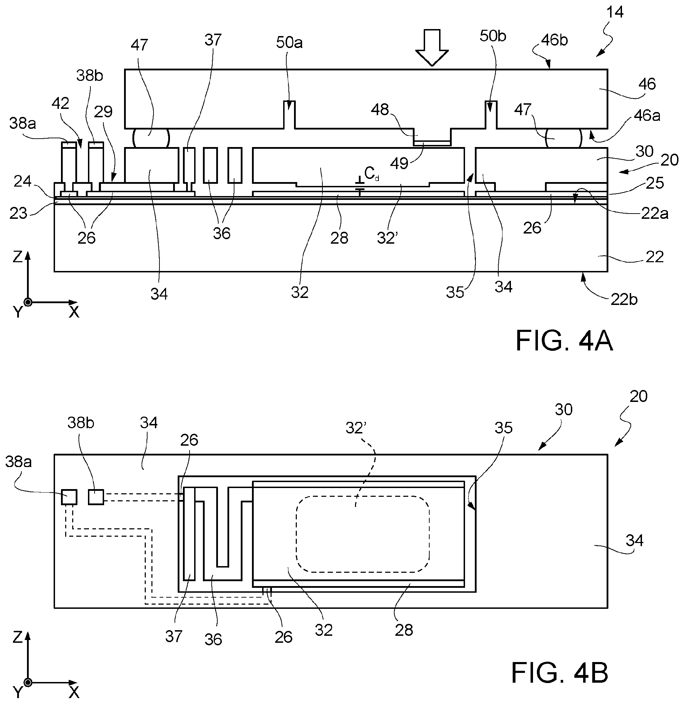

In greater detail, with reference now to Figures 4A and 4B the aforesaid detection structure 14 of the microelectromechanical button device 5 is provided in a respective die 20 of semiconductor material, in particular silicon, comprising a substrate 22.

The substrate 22 has a front surface 22a and a rear surface 22b, the latter being designed to be coupled to the aforesaid supporting layer 12 of the package 6 of the microelectromechanical button device 5 (in a way here not illustrated and as represented in Figure 3).

On the front surface 22a, the detection structure 14 comprises a thermal-oxide layer 23, laid evenly on the same front surface 22a, and a dielectric layer 24, made for example of aluminium oxide or aluminium oxynitride, laid evenly on the aforesaid thermal-oxide layer 23; for reasons that will be clarified hereinafter, the dielectric layer 24 has characteristics of chemical etching selectivity with respect to the aforesaid thermal-oxide layer 23.

The detection structure 14 further comprises, on the aforesaid dielectric layer 24, a conductive layer 25, made for example of polysilicon, appropriately patterned to define, separated from one another by openings, conductive pads or paths, designated as a whole by 26, and, in particular, a buried electrode 28, which, as will on the other hand be clarified hereinafter, is designed to form a first plate of a detection capacitor C_{d} (represented schematically just in Figure 4A), with plane and parallel plates, designed to provide an indication of the deformation of the package 6 (and of the operating state, pressed or not pressed, of the microelectromechanical button device 5).

In this embodiment, the buried electrode 28 is fixed, being rigidly coupled to the substrate 22 (via underlying portions of the aforesaid thermal-oxide layer 23 and dielectric layer 24).

The detection structure 14 further comprises a structural layer 30, in particular an epitaxial-silicon layer, formed on the aforesaid conductive layer 25.

The above structural layer 30 is defined and appropriately patterned to form a mobile electrode 32, suspended at a distance over the buried electrode 28, which is designed to form a second plate of the aforesaid detection capacitor C_{d} (as will be discussed hereinafter, definition of the aforesaid mobile electrode 32 envisages release of part of the structural layer 30 via etching and removal of part of a sacrificial oxide layer 29, formed on the conductive layer 25).

In particular, in the embodiment illustrated in Figures 4A and 4B, the aforesaid mobile electrode 32 has a substantially rectangular shape in the horizontal plane xy, with a greater extension along a first horizontal axis x and a smaller extension along a second horizontal axis y (which defines with the first horizontal axis x the aforesaid horizontal plane xy); the mobile electrode 32 further has an active part 32' projecting at the centre in a vertical direction (along the vertical axis z) that faces the buried electrode 28, at a shorter distance therefrom so as to define the aforesaid capacitive coupling. The buried electrode 28 itself has a rectangular shape in the horizontal plane xy, with an extension equal to or greater than the corresponding extension of the mobile electrode 32.

The structural layer 30 is further defined so as to form: an external frame 34, which in the embodiment illustrated has a rectangular ring shape that internally defines a window 35 in which the mobile electrode 32 is located; and an elastic suspension element 36, which in the example has a folded or serpentine conformation.

In detail, the aforesaid elastic suspension element 36 has a first end coupled to the mobile electrode 32, on a first short side of the same mobile electrode 32, and a second end fixedly coupled to the substrate 22.

In the example illustrated, the above second end is connected to an anchorage element 37 formed starting from the aforesaid structural layer 30 and coupled underneath to one of the aforesaid conductive pads or paths 26 formed on the substrate 22.

In a way not illustrated, it is, however, pointed out that the second end of the elastic suspension element 36 could alternatively be coupled to a facing side of the external frame 34.

The mobile electrode 32 is in any case suspended in cantilever fashion over the buried electrode 28, and the aforesaid elastic suspension element 36 enables deflection thereof in the direction of the vertical axis z, towards the underlying buried electrode 28.

The detection structure 14 further comprises, on the structural layer 30, outside the external frame 34, a first contact pad 38a and a second contact pad 38b, which are made of metal material.

The above first and second contact pads 38a, 38b are electrically coupled to respective conductive pads or paths 26 formed in the aforesaid conductive layer 25, through a respective portion of the structural layer 30, said portions of the structural layer 30 being separated from one another and being further separated from the external frame 34 by respective openings 42 provided through the same structural layer 30.

In particular, the first and second contact pads 38a, 38b are electrically coupled, respectively, to the buried electrode 28 and to the mobile electrode 32 by a first conductive path and a second conductive path, respectively. The first conductive path comprises a respective portion of the structural layer 30, a respective conductive pad or path 26, the anchorage element 37, and the elastic suspension element 36; the second conductive path comprises a respective portion of the structural layer 30 and a respective conductive pad or path 26, which reaches the aforesaid buried electrode 28.

The detection structure 14 further comprises a cap 46, of deformable material, in particular deformable silicon, arranged above the aforesaid structural layer 30, to which it is coupled by bonding regions 47, for example in the form of bumps of an appropriate bonding material.

The above cap 46 has a first main surface 46a facing the structural layer 30 and a second main surface 46b, which is vertically opposite to the first main surface 46a and defines part of the aforesaid first main surface 6a of the package 6 (see also Figure 3).

In particular, the aforesaid cap 46 has an actuation projection 48, which extends vertically from the first main surface 46a towards the structural layer 30, has, for example, a square or rectangular shape in the horizontal plane xy, and has one end 49 coated by thermal oxide, arranged in contact with or in strict proximity to the mobile electrode 32, in the example in a position corresponding to the second short side, opposite to the first short side coupled to the elastic suspension element 36.

The cap 46 further has, on opposite sides of the aforesaid actuation portion 48 along the first horizontal axis x, a first recess 50a and a second recess 50b that extend from the first main surface 46a towards the inside of the same cap 46, in a vertical direction (along the vertical axis z) for example approximately for one half of the thickness of the cap 46 (the actuation portion 48 is therefore interposed between the first recess 50a and the second recess 50b along the first horizontal axis x). In the example illustrated, these first and second recesses 50a, 50b are arranged vertically at the first short side and, respectively, at the second short side of the mobile electrode 32.

As illustrated schematically in the above Figure 4A, the pressure applied to the cap 46 on the actuation portion 48 (corresponding to the external force Fₑₓₜ applied on the case 2 of the electronic apparatus 1 at the user interface element 4) causes a deflection of the mobile electrode 32 and its approach to the buried electrode 28, with a consequent capacitive variation of the detection capacitor C_{d}.

The above capacitive variation may be acquired and processed, for example by the electronic circuit 15 within the package 6 of the microelectromechanical button device 5.

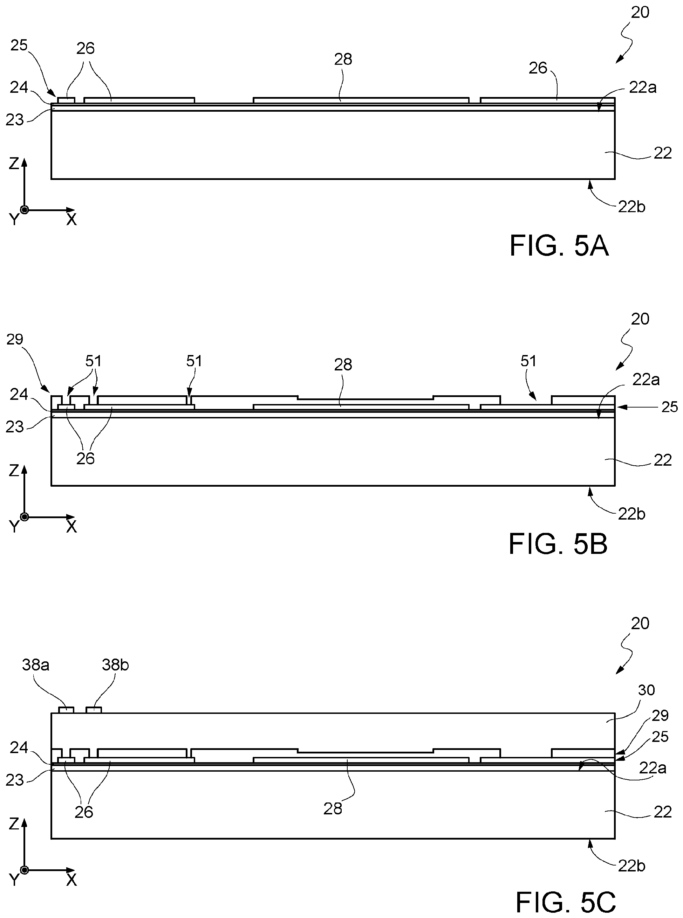

With reference first to Figure 5A, the process for manufacturing of the aforesaid detection structure 14 is now described; this process envisages first formation of the thermal-oxide layer 23 by oxidation of the front surface 22a of the substrate 22 and then formation of the dielectric layer 24 on the thermal-oxide layer 23 (the thermal-oxide layer 23 and the dielectric layer 24 forming together a combined layer of permanent-dielectric).

Then, as shown in Figure 5A, the conductive layer 25 is formed on the aforesaid dielectric layer 24, made, for example, of polysilicon; the same conductive layer 25 is then defined and patterned by an appropriate photolithographic mask, to form the conductive pads or paths 26 and the buried electrode 28.

Next (Figure 5B), the sacrificial oxide layer 29 is formed on the conductive layer 25 and is then defined and patterned by a respective photolithographic mask, to form openings 51, which are to enable access to respective conductive pads or paths 26 previously defined.

Next (Figure 5c), epitaxial growth is carried out to form the structural layer 30 on the aforesaid sacrificial oxide layer 29, followed by an appropriate step of CMP (Chemical Mechanical Polishing) of a corresponding top surface.

As shown in the same Figure 5C, the first and second contact pads 38a, 38b are then formed by deposition and etching of a layer of metal material on the structural layer 30.

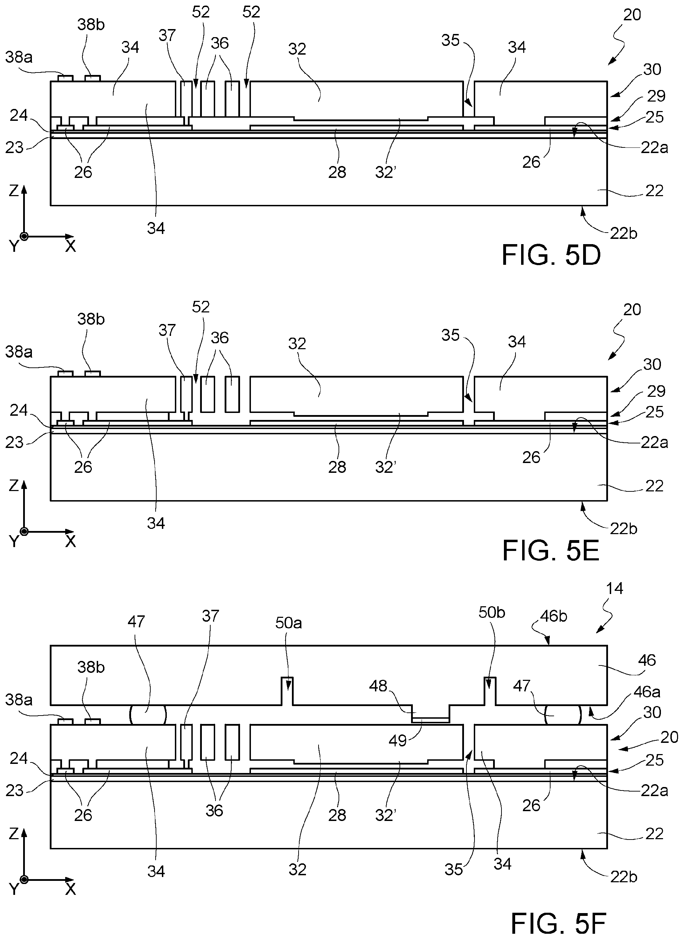

A step of etching of the aforesaid structural layer 30 is then carried out (Figure 5D) to form trenches 52 (in Figure 5D some of these trenches are represented by way of example) throughout the thickness of the structural layer 30, which enable access to the underlying sacrificial oxide layer 29. These trenches 52 further define the shape of the elements formed in the structural layer 30, which in particular comprise the mobile electrode 32, the external frame 34, the elastic suspension element 36, and the anchorage element 37.

As shown in Figure 5E, a chemical etching is then carried out, for example using hydrofluoric acid (HF), of the aforesaid sacrificial oxide layer 29 through the trenches 52. This etching stops on the dielectric layer 24 and leads to release of the mobile electrode 32 and of the associated elastic suspension element 36, which thus remain suspended above the underlying substrate 22, at a certain distance from the underlying conductive layer 25.

The process then continues (Figure 5F) with bonding, on the structural layer 30, of the cap 46 by the bonding regions 47 (the cap 46 itself having previously been machined to form the actuation portion 48 and the first and second recesses 50a, 50b).

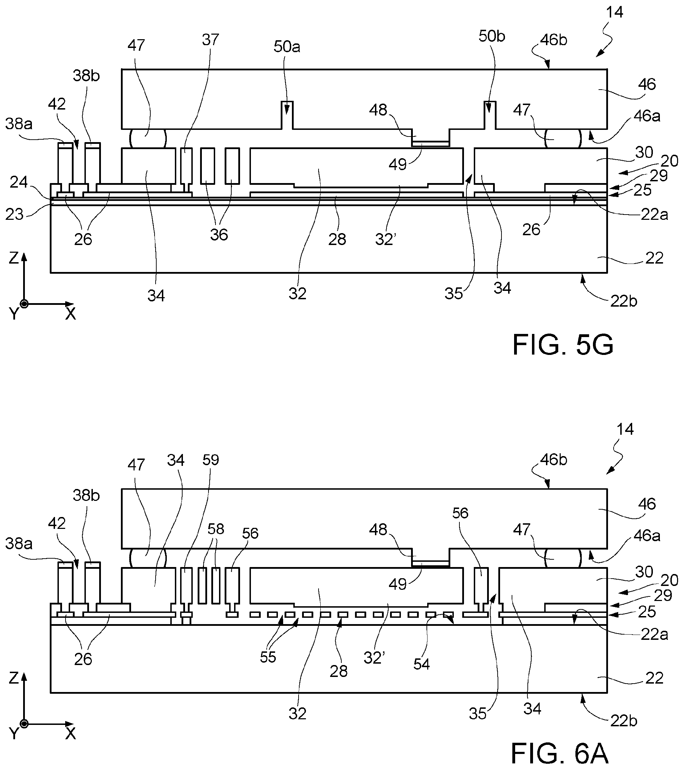

As shown in Figure 5G, the above cap 46 is then appropriately patterned by an etching step, so as to make the underlying first and second contact pads 38a, 38b on the structural layer 30 accessible and further enable formation of the openings 42 through the same structural layer 30.

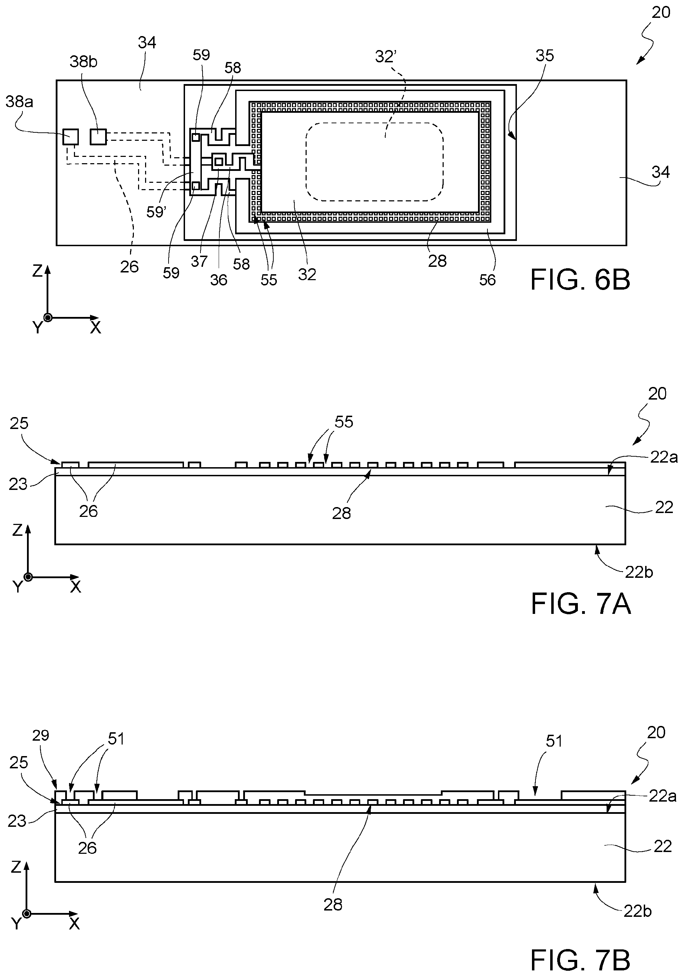

A description of a further embodiment of the detection structure 14 is now presented, with reference to Figures 6A and 6B; this embodiment envisages that also the buried electrode 28, just as the mobile electrode 32, is elastically decoupled from the substrate 22 of the die 20.

In detail, in this embodiment, the buried electrode 28, once again formed starting from the conductive layer 25, is suspended at a distance above the top surface 22a of the substrate 22, a buried cavity 54 being present between the top surface 22a and the same buried electrode 28. It should be noted that a plurality of openings 55 are formed through the buried electrode 28 in a vertical direction. These openings 55 facilitate, as on the other hand will be highlighted hereinafter, removal of sacrificial material for the formation of the aforesaid buried cavity 54 underneath the same buried electrode 28.

The buried electrode 28 is supported in its position suspended above the buried cavity 54 by an overlying inner frame 56, formed starting from the structural layer 30 (as likewise are the mobile electrode 32 and the external frame 34). In particular, coupling between the buried electrode 28 and the aforesaid inner frame 56 is provided at the periphery or edge of the same buried electrode 28.

In the embodiment illustrated in Figure 6B, the buried electrode 28 has a substantially rectangular shape in the horizontal plane xy, with a greater extension than the corresponding extension of the mobile electrode 32 in the same horizontal plane xy; in other words, the inner frame 56 externally surrounds the mobile electrode 32.

The aforesaid inner frame 56 is elastically decoupled from the substrate 22 by respective elastic suspension elements 58, in the example illustrated having a folded shape and an extension along the first horizontal axis x of the horizontal plane xy, on opposite sides of the aforesaid elastic suspension element 36 with respect to the second horizontal axis y.

In detail, the above elastic suspension elements 58 have a respective first end coupled to the inner frame 56 and a respective second end fixedly coupled to the substrate 22.

In the example illustrated, the above second end is connected to a respective anchorage element 59 formed starting from the aforesaid structural layer 30 and coupled underneath to one of the aforesaid conductive paths 26 formed on the substrate 22. In the same example, the above anchorage elements 59 are further coupled together by a connection element 59', which is also formed in the structural layer 30 and has an extension along the second horizontal axis y.

In a way not shown, it is, however, pointed out that just one elastic suspension element 58 coupled to the inner frame 56 could alternatively be provided. Furthermore, the second end of the aforesaid elastic suspension element 58 could be coupled to a facing side of the external frame 34, for example arranged on an opposite side with respect to the side of the external frame 34 coupled to the anchorage element 37 of the elastic suspension element 36.

Advantageously, in this embodiment, elastic decoupling of the buried electrode 28 from the substrate 22 allows the performance of the detection structure 14 not to be affected by possible deformation of the same substrate 22, for example due to thermal stresses or ageing phenomena.

With initial reference to Figure 7A, a description of the process for manufacturing the aforesaid detection structure 14 is now presented, in relation to the further embodiment just described.

The above process envisages also in this case formation of the thermal-oxide layer 23 by oxidation of the front surface 22a of the substrate 22. In this case, instead, the dielectric layer 24 is not formed on the thermal-oxide layer 23, but rather directly the conductive layer 25, made, for example, of polysilicon, which is defined and patterned by an appropriate photolithographic mask to form the conductive pads or paths 26 and the buried electrode 28. It should be noted that this step of photolithographic etching leads also to definition of the openings 55 through the buried electrode 28.

Next (Figure 7B), 5 the sacrificial oxide layer 29 is formed on the conductive layer 2 and is then defined and patterned by the respective photolithographic mask. In particular, in this case, the sacrificial oxide layer 29 enters and fills the aforesaid openings 55.

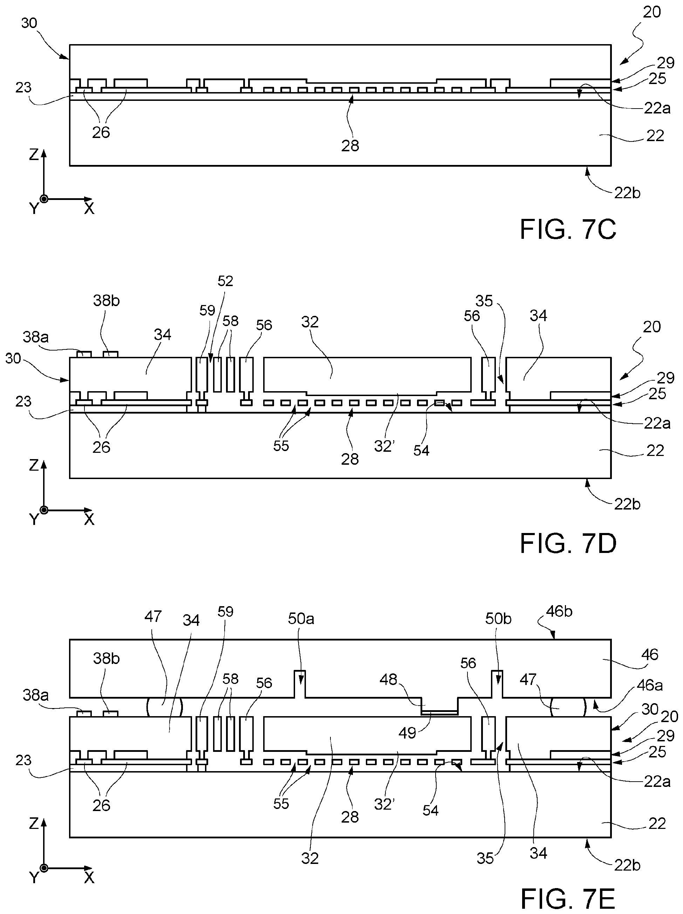

Next (Figure 7c), epitaxial growth is carried out to form the structural layer 30 on the aforesaid sacrificial oxide layer 29.

As shown in Figure 7D, the first and second contact pads 38a, 38b are then formed on the structural layer 30. The step of etching of the aforesaid structural layer 30 is then carried out to form the trenches 52 throughout the thickness of the same structural layer 30, enabling access to the underlying sacrificial oxide layer 29.

The above trenches 52 further define the elements formed in the structural layer 30, in particular the mobile electrode 32, the external frame 34, the inner frame 56, the elastic suspension elements 36 and 58 and the anchorage elements 37, 59 (the cross-sectional view of Figure 7D showing only the elastic suspension element 58 and the corresponding anchorage element 59).

As shown once again in Figure 7D, chemical etching, for example using hydrofluoric acid (HF), of the aforesaid sacrificial oxide layer 29 is then carried out through the trenches 52. Etching stops in this case on the front surface 22a of the substrate 22 and leads to release of the mobile electrode 32 and, in this case, also of the buried electrode 28 (as well as of the external and inner frames 34, 56 and of the elastic suspension elements 36, 58).

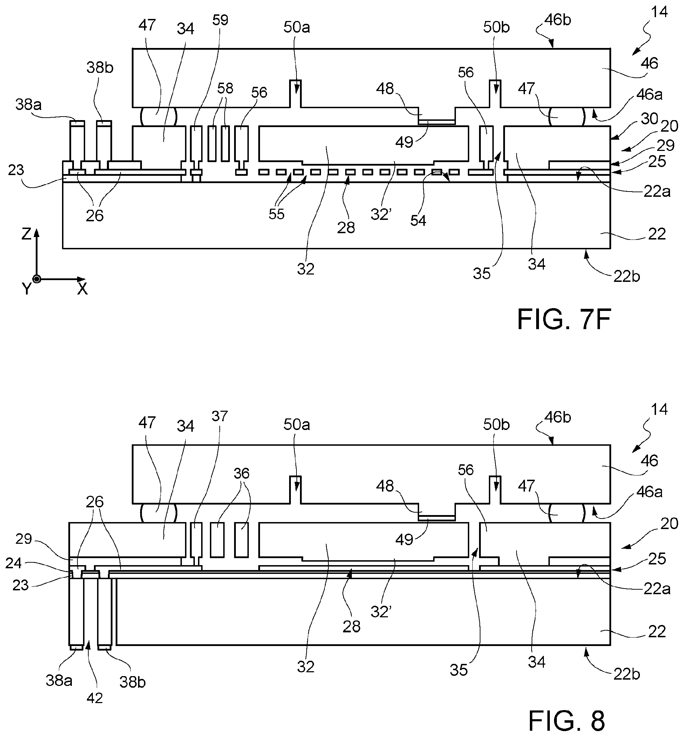

The process then continues, as described previously (Figure 7E) with coupling of the cap 46 on the structural layer 30, by the bonding regions 47, and further (Figure 7F) with machining of the cap 46 itself so as to make the underlying first and second contact pads 38a, 38b accessible and to further enable formation of the openings 42 through the structural layer 30.

The advantages of the present solution are clear from the foregoing description.

In any case, it is once again pointed out that the solution described enables provision of a user interface element for an electronic apparatus, in particular of a portable or wearable type, which is intrinsically waterproof and has several advantages over traditional solutions, amongst which: a reduced energy consumption, low costs, and low complexity of manufacturing, high yield, accuracy, and speed in detection.

Finally, it is clear that modifications and variations may be made to what has been described and illustrated herein, without thereby departing from the scope of the present invention, as defined in the annexed claims.

For instance, it is pointed out that the first and second recesses 50a, 50b might not be provided in the cap 46 at the sides of the actuation portion 48.

Furthermore, as shown in Figure 8, a possible alternative embodiment may envisage formation of the first and second contact pads 38a, 38b on the back of the substrate 22, on the corresponding rear surface 22b.

In this case, the respective pads 26 formed in the conductive layer 25 extend through the underlying dielectric layer 24 and thermal-oxide layer 23 to reach respective portions of the substrate 22, which extend vertically throughout its thickness, separated by the openings 42, which in this case are obtained as trenches through the same substrate 22.

In a possible embodiment, the package 6 of the microelectromechanical button device 5 may further comprise just the detection structure 14 and not the associated electronic circuit 15. In this case, the functions of driving of the buried and mobile electrodes 28, 32 and of processing of the capacitive variation of the detection capacitor C_{d} may be carried out by an electronic circuitry external to the microelectromechanical button device 5, for example coupled to the PCB 10.

Furthermore, it is highlighted that it is possible to implement a detection in a resonance condition of the capacitive variation of the detection capacitor C_{d} formed between the mobile electrode 32 and the buried electrode 28 of the detection structure 14.

## Claims

1. A microelectromechanical button device (5), comprising a detection structure (14) having:
a substrate (22) of semiconductor material with a front surface (22a) and a rear surface (22b), which have an extension in a horizontal plane (xy) and are opposite to one another along a vertical axis (z), orthogonal to the horizontal plane (xy);
a buried electrode (28) arranged on the substrate (22);
a mobile electrode (32), arranged in a structural layer (30) overlying the substrate (22) and elastically suspended above the buried electrode (28) at a separation distance so as to form a detection capacitor (C_{d}); and
a cap (46) coupled over the structural layer (30) and having a first main surface (46a) facing the structural layer (30) and a second main surface (46b), opposite to the first main surface (46a) along the vertical axis (z);
wherein said cap (46) has, on said first main surface (46a), an actuation portion (48) arranged on the mobile electrode (32) and configured so as to cause, in the presence of a pressure applied on the second main surface (46b), a deflection of the mobile electrode (32) and its approach to the buried electrode (28), with a consequent capacitive variation of the detection capacitor (C_{d}), said capacitive variation being indicative of an actuation of said microelectromechanical button device (5),
wherein said detection structure (14) further comprises an elastic suspension element (36), arranged in said structural layer (30) and having a first end coupled to the mobile electrode (32) and a second end fixedly coupled to the substrate (22), said elastic suspension element (36) being configured to support said mobile electrode (32) suspended in cantilever fashion above the buried electrode (28) and to enable deflection thereof towards the underlying buried electrode (28),
**characterized in that** said second end is connected to an anchorage element (34, 37) arranged in the structural layer (30) and fixedly coupled to said substrate (22) by a conductive element (26), configured for electrical connection to said mobile electrode (32).

2. The device according to claim 1, wherein said cap (46) has, on opposite sides of the aforesaid actuation portion (48), a first recess (50a) and a second recess (50b), which extend within the cap (46), in the direction of the vertical axis (z); said actuation portion (48) being interposed between said first recess (50a) and second recess (50b) along a direction (x) of said horizontal plane (xy).

3. The device according to any one of the preceding claims, wherein said actuation portion (48) is a projection, which extends along the vertical axis (z) starting from the first main surface (46a) of the cap (46) towards the structural layer (30) and has one end (49) arranged in contact with, or in strict proximity of, the mobile electrode (32).

4. The device according to any of the preceding claims, wherein said detection structure (14) further comprises an external frame (34) formed in said structural layer (30) and internally defining a window (35) wherein the mobile electrode (32) is arranged; said cap (46) being coupled to said external frame (34) by bonding regions (47).

5. The device according to claim 4, wherein said anchorage element is defined by a portion of said external frame (34).

6. The device according to any one of the preceding claims, wherein said buried electrode (28) is suspended at a distance above the top surface (22a) of the substrate (22), a buried cavity (54) being arranged between said top surface (22a) and said buried electrode (28).

7. The device according to claim 6, wherein said buried electrode (28) is supported in its position suspended above the buried cavity (54) by an overlying inner frame (56), arranged in the structural layer (30); wherein said inner frame (56) is elastically decoupled from said substrate (22) by at least one respective elastic suspension element (58) having a respective first end coupled to the inner frame (56) and a second end fixedly coupled to the substrate (22).

8. The device according to claim 7, wherein the second end of said respective elastic suspension element (58) is connected to a respective anchorage element (59) arranged in the structural layer (30) and fixedly coupled to said substrate (22) by a respective conductive element (26), configured for electrical connection to said buried electrode (28) .

9. The device according to any one of the preceding claims, further comprising a package (6) having a supporting layer (12), with a respective front surface (12a), to which said detection structure (14) is coupled, and a respective rear surface (12b), opposite to the respective front surface (12a), which defines a main outer surface (6b) of the package (6); said package (6) further comprising a coating (18) that covers and coats laterally the detection structure (14) to define part of outer lateral surfaces (6c) and part of a further main outer surface (6a) of the package (6), part of said further main outer surface (6a) being defined by the second main surface (46b) of the cap (46) of said detection structure (14) .

10. The device according to claim 9, further comprising an electronic circuit (15), associated with the detection structure (14), provided in a respective die of semiconductor material, coupled to said supporting layer (12) arranged alongside said detection structure (14).

11. A user interface element (4) for a portable or wearable electronic apparatus (1), comprising: the microelectromechanical button device (5) according to any one of the preceding claims; and, moreover, a deformable portion (3) of a case (2) of the electronic apparatus (1), mechanically coupled to the second main surface (46b) of the cap (46) of said microelectromechanical button device (5).

12. The user interface element according to claim 11, wherein said pressure is the result of a deformation of the deformable portion (3) of the case (2) of the electronic apparatus (1), due to an external force (Fₑₓₜ) applied on said deformable portion (3) from outside of said case (2) for actuation of said microelectromechanical button device (5).

13. A portable or wearable electronic apparatus (1) comprising the user interface element (4) according to claim 11 or 12, which defines a physical button.

14. The electronic apparatus according to claim 13, comprising: a chamber (7) inside the case (2), in which said microelectromechanical button device (5) is arranged; a flexible support (9) integrating electrical-connection paths (9') housed within the chamber (7) and to which said microelectromechanical button device (5) is electrically and mechanically coupled; and a printed-circuit board (11), housed within the chamber (7) and fixed to the case (2); wherein said flexible support (9) is coupled to said printed-circuit board (11) by a connection element (10).

15. A process for the manufacturing of a microelectromechanical button device (5), comprising:
providing a substrate (22) of semiconductor material having a front surface (22a) and a rear surface (22b), which have an extension in a horizontal plane (xy) and are opposite to one another along a vertical axis (z), orthogonal to the horizontal plane (xy);
forming a buried electrode (28), via definition of a conductive layer (25) on the substrate (22);
forming a mobile electrode (32), via definition of a structural layer (30) overlying the substrate (22), elastically suspended above the buried electrode (28) at a separation distance so as to form a detection capacitor (C_{d}); and
coupling a cap (46) on the structural layer (30), having a first main surface (46a) that faces the structural layer (30) and a second main surface (46b), opposite to the first main surface (46a) along the vertical axis (z), that is designed to be mechanically coupled to a deformable portion (3) of a case (2) of an electronic apparatus (1) of a portable or wearable type;
further comprising forming an actuation portion (48) of said cap (46), at said first main surface (46a), said actuation portion (48) being arranged over the mobile electrode (32) and being configured to cause, in the presence of a pressure applied on the second main surface (46b), a deflection of the mobile electrode (32) and its approach to the buried electrode (28), with a consequent capacitive variation of the detection capacitor (C_{d}), said capacitive variation being indicative of an actuation of said microelectromechanical button device (5), further comprising forming an elastic suspension element (36), via definition of said structural layer (30), having a first end coupled to the mobile electrode (32) and a second end fixedly coupled to the substrate (22), said elastic suspension element (36) being configured to support said mobile electrode (32) suspended in cantilever fashion above the buried electrode (28) and to enable deflection thereof towards the underlying buried electrode (28),
**characterized in that** forming the elastic suspension element (36) comprises forming said second end connected to an anchorage element (34, 37) arranged in the structural layer (30) and fixedly coupled to said substrate (22) by a conductive element (26), configured for electrical connection to said mobile electrode (32).

16. The process according to claim 15, wherein forming said buried electrode (28) comprises forming said buried electrode (28) suspended at a distance above the top surface (22a) of the substrate (22), a buried cavity (54) being arranged between said top surface (22a) and said buried electrode (28); further comprising forming, via definition of said structural layer (30): an inner frame (56), which supports, in its position suspended above the buried cavity (54), the underlying buried electrode (28); and a respective elastic suspension element (58), which has a respective first end coupled to the inner frame (56) and a second end fixedly coupled to the substrate (22).

17. The process according to claim 15 or 16, further comprising forming a first recess (50a) and a second recess (50b), which extend within the cap (46), in the direction of the vertical axis (z), on opposite sides of said actuation portion (48).

## Patentansprüche

1. Mikroelektromechanische Tastenvorrichtung (5), umfassend eine Detektionsstruktur (14) mit:
einem Substrat (22) aus Halbleitermaterial mit einer vorderen Fläche (22a) und einer hinteren Fläche (22b), die eine Erstreckung in einer horizontalen Ebene (xy) aufweisen und sich entlang einer vertikalen Achse (z) gegenüberliegen, die orthogonal zu der horizontalen Ebene (xy) verläuft;
einer vergrabenen Elektrode (28), die auf dem Substrat (22) angeordnet ist;
einer beweglichen Elektrode (32), die in einer das Substrat (22) überlagernden Strukturschicht (30) angeordnet und elastisch in einem Trennabstand über der vergrabenen Elektrode (28) aufgehängt ist, um einen Detektionskondensator (C_{d}) zu bilden; und
einer Kappe (46), die über die Strukturschicht (30) gekoppelt ist und eine erste Hauptfläche (46a) aufweist, die der Strukturschicht (30) zugewandt ist, und eine zweite Hauptfläche (46b), die der ersten Hauptfläche (46a) entlang der vertikalen Achse (z) gegenüberliegt;
wobei die Kappe (46) auf der ersten Hauptfläche (46a) einen Betätigungsabschnitt (48) aufweist, der auf der beweglichen Elektrode (32) angeordnet und so eingerichtet ist, dass er bei Vorhandensein eines auf die zweite Hauptfläche (46b) ausgeübten Drucks eine Auslenkung der beweglichen Elektrode (32) und deren Annäherung an die vergrabene Elektrode (28) mit einer daraus resultierenden kapazitiven Variation des Detektionskondensators (C_{d}) verursacht, wobei die kapazitive Variation auf eine Betätigung der mikroelektromechanischen Tastenvorrichtung (5) hinweist,
**wobei** die Detektionsstruktur (14) ferner ein elastisches Aufhängungselement (36) umfasst, das in der Strukturschicht (30) angeordnet ist und ein erstes Ende aufweist, das mit der beweglichen Elektrode (32) gekoppelt ist, und ein zweites Ende, das fest mit dem Substrat (22) gekoppelt ist, wobei das elastische Aufhängungselement (36) so eingerichtet ist, dass es die bewegliche Elektrode (32) stützt, die freitragend über der vergrabenen Elektrode (28) aufgehängt ist, und deren Auslenkung in Richtung der darunter liegenden vergrabenen Elektrode (28) ermöglicht,
**dadurch gekennzeichnet, dass** das zweite Ende mit einem Verankerungselement (34, 37) verbunden ist, das in der Strukturschicht (30) angeordnet und durch ein leitfähiges Element (26) fest mit dem Substrat (22) gekoppelt ist, das für die elektrische Verbindung mit der beweglichen Elektrode (32) eingerichtet ist.

2. Vorrichtung nach Anspruch 1, wobei die Kappe (46) auf gegenüberliegenden Seiten des vorgenannten Betätigungsabschnitts (48) eine erste Vertiefung (50a) und eine zweite Vertiefung (50b) aufweist, die sich innerhalb der Kappe (46) in Richtung der vertikalen Achse (z) erstrecken; wobei der Betätigungsabschnitt (48) zwischen der ersten Vertiefung (50a) und der zweiten Vertiefung (50b) entlang einer Richtung (x) der horizontalen Ebene (xy) eingefügt ist.

3. Vorrichtung nach einem der vorhergehenden Ansprüche, wobei der Betätigungsabschnitt (48) ein Vorsprung ist, der sich beginnend von der ersten Hauptfläche (46a) der Kappe (46) in Richtung der Strukturschicht (30) entlang der vertikalen Achse (z) erstreckt und ein Ende (49) aufweist, das in Kontakt mit der beweglichen Elektrode (32) oder in unmittelbarer Nähe zu dieser angeordnet ist.

4. Vorrichtung nach einem der vorhergehenden Ansprüche, wobei die Detektionsstruktur (14) ferner einen äußeren Rahmen (34) umfasst, der in der Strukturschicht (30) gebildet ist und ein Fenster (35) intern definiert, in dem die bewegliche Elektrode (32) angeordnet ist; wobei die Kappe (46) durch Klebebereiche (47) mit dem äußeren Rahmen (34) gekoppelt ist.

5. Vorrichtung nach Anspruch 4, wobei das Verankerungselement durch einen Abschnitt des Außenrahmens (34) definiert ist.

6. Vorrichtung nach einem der vorhergehenden Ansprüche, wobei die vergrabene Elektrode (28) in einem Abstand über der oberen Fläche (22a) des Substrats (22) aufgehängt ist, wobei ein vergrabener Hohlraum (54) zwischen der oberen Fläche (22a) und der vergrabenen Elektrode (28) angeordnet ist.

7. Vorrichtung nach Anspruch 6, wobei die vergrabene Elektrode (28) in ihrer über dem vergrabenen Hohlraum (54) aufgehängten Position von einem darüber liegenden inneren Rahmen (56) getragen wird, der in der Strukturschicht (30) angeordnet ist; wobei der innere Rahmen (56) von dem Substrat (22) durch mindestens ein jeweiliges elastisches Aufhängungselement (58) elastisch entkoppelt ist, das ein jeweiliges erstes Ende aufweist, das mit dem inneren Rahmen (56) gekoppelt ist, und ein zweites Ende, das fest mit dem Substrat (22) gekoppelt ist.

8. Vorrichtung nach Anspruch 7, wobei das zweite Ende des jeweiligen elastischen Aufhängungselements (58) mit einem jeweiligen Verankerungselement (59) verbunden ist, das in der Strukturschicht (30) angeordnet und durch ein jeweiliges leitfähiges Element (26) fest mit dem Substrat (22) gekoppelt ist, das für eine elektrische Verbindung mit der vergrabenen Elektrode (28) eingerichtet ist.

9. Vorrichtung nach einem der vorhergehenden Ansprüche, ferner umfassend eine Verpackung (6) mit einer Stützschicht (12), mit einer jeweiligen vorderen Fläche (12a), an die die Detektionsstruktur (14) gekoppelt ist, und einer der jeweiligen vorderen Fläche (12a) gegenüberliegenden jeweiligen hinteren Fläche (12b), die eine äußere Hauptfläche (6b) der Verpackung (6) definiert; wobei die Verpackung (6) ferner eine Beschichtung (18) umfasst, die die Detektionsstruktur (14) seitlich abdeckt und beschichtet, um einen Teil der äußeren seitlichen Flächen (6c) und einen Teil einer weiteren äußeren Hauptfläche (6a) der Verpackung (6) zu definieren, wobei ein Teil der weiteren äußeren Hauptfläche (6a) durch die zweite Hauptfläche (46b) der Kappe (46) der Detektionsstruktur (14) definiert ist.

10. Vorrichtung nach Anspruch 9, ferner umfassend eine elektronische Schaltung (15), die der Detektionsstruktur (14) zugeordnet ist, die in einem jeweiligen Chip aus Halbleitermaterial vorgesehen ist, die mit der Stützschicht (12) gekoppelt ist, die neben der Detektionsstruktur (14) angeordnet ist.

11. Benutzerschnittstellenelement (4) für eine mobile oder tragbare elektronische Einrichtung (1), umfassend: die mikroelektromechanische Tastenvorrichtung (5) nach einem der vorhergehenden Ansprüche; und darüber hinaus einen verformbaren Abschnitt (3) eines Gehäuses (2) der elektronischen Einrichtung (1), der mechanisch mit der zweiten Hauptfläche (46b) der Kappe (46) der mikroelektromechanischen Tastenvorrichtung (5) gekoppelt ist.

12. Benutzerschnittstellenelement nach Anspruch 11, wobei der Druck das Ergebnis einer Verformung des verformbaren Abschnitts (3) des Gehäuses (2) der elektronischen Einrichtung (1) aufgrund einer externen Kraft (Fₑₓₜ) ist, die von außerhalb des Gehäuses (2) auf den verformbaren Abschnitt (3) zur Betätigung der mikroelektromechanischen Tastenvorrichtung (5) ausgeübt wird.

13. Mobile oder tragbare elektronische Einrichtung (1), die das Benutzerschnittstellenelement (4) nach Anspruch 11 oder 12 umfasst, das eine physische Taste definiert.

14. Elektronische Einrichtung nach Anspruch 13, umfassend: eine Kammer (7) innerhalb des Gehäuses (2), in der die mikroelektromechanische Tastenvorrichtung (5) angeordnet ist; einen flexiblen Träger (9), der elektrische Verbindungspfade (9') integriert, die innerhalb der Kammer (7) untergebracht sind und an die die mikroelektromechanische Tastenvorrichtung (5) elektrisch und mechanisch gekoppelt ist; und eine Leiterplatte (11), die innerhalb der Kammer (7) untergebracht und an dem Gehäuse (2) befestigt ist; wobei der flexible Träger (9) durch ein Verbindungselement (10) mit der Leiterplatte (11) gekoppelt ist.

15. Verfahren zur Herstellung einer mikroelektromechanischen Tastenvorrichtung (5), umfassend:
Bereitstellen eines Substrats (22) aus Halbleitermaterial mit einer vorderen Fläche (22a) und einer hinteren Fläche (22b), die eine Erstreckung in einer horizontalen Ebene (xy) aufweisen und sich entlang einer vertikalen Achse (z) gegenüberliegen, die orthogonal zu der horizontalen Ebene (xy) verläuft;
Bilden einer vergrabenen Elektrode (28) durch Definition einer leitfähigen Schicht (25) auf dem Substrat (22);
Bilden einer beweglichen Elektrode (32), durch Definition einer das Substrat (22) überlagernden Strukturschicht (30), die elastisch in einem Trennabstand über der vergrabenen Elektrode (28) aufgehängt ist, um einen Detektionskondensator (C_{d}) zu bilden; und
Koppeln einer Kappe (46) an die Strukturschicht (30), die eine erste Hauptfläche (46a) aufweist, die der Strukturschicht (30) zugewandt ist, und eine zweite Hauptfläche (46b), die der ersten Hauptfläche (46a) entlang der vertikalen Achse (z) gegenüberliegt und so ausgelegt ist, dass sie mechanisch mit einem verformbaren Abschnitt (3) eines Gehäuses (2) einer elektronischen Einrichtung (1) eines mobilen oder tragbaren Typs gekoppelt werden kann;
ferner umfassend das Bilden eines Betätigungsabschnitts (48) der Kappe (46) an der ersten Hauptfläche (46a), wobei der Betätigungsabschnitt (48) über der beweglichen Elektrode (32) angeordnet und so eingerichtet ist, dass er bei Vorhandensein eines auf die zweite Hauptfläche (46b) ausgeübten Drucks eine Auslenkung der beweglichen Elektrode (32) und deren Annäherung an die vergrabene Elektrode (28) mit einer daraus resultierenden kapazitiven Variation des Detektionskondensators (C_{d}) verursacht, wobei die kapazitive Variation auf eine Betätigung der mikroelektromechanischen Tastenvorrichtung (5) hinweist,
ferner umfassend das Bilden eines elastischen Aufhängungselements (36) durch Definition der Strukturschicht (30), wobei ein erstes Ende mit der beweglichen Elektrode (32) gekoppelt und ein zweites Ende fest mit dem Substrat (22) gekoppelt ist, wobei das elastische Aufhängungselement (36) so eingerichtet ist, dass es die bewegliche Elektrode (32) stützt, die freitragend über der vergrabenen Elektrode (28) aufgehängt ist, und deren Auslenkung in Richtung der darunter liegenden vergrabenen Elektrode (28) ermöglicht,
**dadurch gekennzeichnet, dass** das Bilden des elastischen Aufhängungselements (36) das Bilden des zweiten Endes umfasst, das mit einem Verankerungselement (34, 37) verbunden ist, das in der Strukturschicht (30) angeordnet und durch ein leitfähiges Element (26) fest mit dem Substrat (22) gekoppelt ist, das für eine elektrische Verbindung mit der beweglichen Elektrode (32) eingerichtet ist.

16. Verfahren nach Anspruch 15, wobei das Bilden der vergrabenen Elektrode (28) das Bilden der vergrabenen Elektrode (28) umfasst, die in einem Abstand über der oberen Fläche (22a) des Substrats (22) aufgehängt ist, wobei ein vergrabener Hohlraum (54) zwischen der oberen Fäche (22a) und der vergrabenen Elektrode (28) angeordnet ist; ferner umfassend das Bilden von Folgendem durch Definition der Strukturschicht (30): einen inneren Rahmen (56), der in seiner über dem vergrabenen Hohlraum (54) aufgehängten Position die darunter liegende vergrabene Elektrode (28) stützt; und ein jeweiliges elastisches Aufhängungselement (58), das ein jeweiliges erstes Ende aufweist, das mit dem inneren Rahmen (56) gekoppelt ist, und ein zweites Ende, das fest mit dem Substrat (22) gekoppelt ist.

17. Verfahren nach Anspruch 15 oder 16, ferner umfassend das Bilden einer ersten Vertiefung (50a) und einer zweiten Vertiefung (50b), die sich innerhalb der Kappe (46) in Richtung der vertikalen Achse (z) auf gegenüberliegenden Seiten des Betätigungsabschnitts (48) erstrecken.

## Revendications

1. Dispositif de bouton microélectromécanique (5) comprenant une structure de détection (14) comportant :
un substrat (22) en matériau semiconducteur ayant une surface avant (22a) et une surface arrière (22b), qui ont une extension dans un plan horizontal (xy) et qui sont à l'opposé l'une de l'autre le long d'un axe vertical (z), orthogonal au plan horizontal (xy) ;
une électrode enfouie (28) placées sur le substrat (22) ;
une électrode mobile (32), placée dans une couche structurelle (30) recouvrant le substrat (22) et suspendue de manière élastique au-dessus de l'électrode enfouie (28) avec une distance de séparation afin de former un condensateur de détection (C_{d}) ; et
un capot (46) accouplé sur la couche structurelle (30) et ayant une première surface principale (46a) en face de la couche structurelle (30) et une deuxième surface principale (46b), à l'opposé de la première surface principale (46a) le long de l'axe vertical (z) ;
dans lequel ledit capot (46) comporte, sur ladite première surface principale (46a), une partie d'actionnement (48) placée sur l'électrode mobile (32) et configurée de manière à provoquer, en présence d'une pression appliquée sur la deuxième surface principale (46b), une déviation de l'électrode mobile (32) et son rapprochement de l'électrode enfouie (28), avec une variation capacitive consécutive du condensateur de détection (C_{d}), ladite variation capacitive indiquant un actionnement dudit dispositif de bouton microélectromécanique (5),
dans lequel ladite structure de détection (14) comprend en outre un élément de suspension élastique (36), placé dans ladite couche structurelle (30) et ayant une première extrémité accouplée à l'électrode mobile (32) et une deuxième extrémité accouplée de manière fixe au substrat (22), ledit élément de suspension élastique (36) étant configuré pour supporter ladite électrode mobile (32) suspendue en porte-à-faux au-dessus de l'électrode enfouie (28) et pour permettre la déviation de celle-ci vers l'électrode enfouie (28) sous-jacente,
**caractérisé en ce que** ladite deuxième extrémité est connectée à un élément d'ancrage (34, 37) placé dans la couche structurelle (30) et accouplé de manière fixe audit substrat (22) par un élément conducteur (26), configuré pour la connexion électrique avec ladite électrode mobile (32).

2. Dispositif selon la revendication 1, dans lequel ledit capot (46) comporte, sur des côtés opposés de ladite partie d'actionnement (48), un premier évidement (50a) et un deuxième évidement (50b), qui s'étendent dans le capot (46), dans la direction de l'axe vertical (z) ; ladite partie d'actionnement (48) étant intercalée entre ledit premier évidement (50a) et ledit deuxième évidement (50b) le long d'une direction (x) dudit plan horizontal (xy).

3. Dispositif selon l'une quelconque des revendications précédentes, dans lequel ladite partie d'actionnement (48) est une protubérance, qui s'étend le long de l'axe vertical (z) à partir de la première surface principale (46a) du capot (46), vers la couche structurelle (30) et qui a une extrémité (49) mise en contact avec, ou à proximité étroite, de l'électrode mobile (32).

4. Dispositif selon l'une quelconque des revendications précédentes, dans lequel ladite structure de détection (14) comprend en outre un cadre externe (34) formé dans ladite couche structurelle (30) et définissant intérieurement une fenêtre (35) dans laquelle est placée l'électrode mobile (32) ; ledit capot (46) étant accouplé audit cadre externe (34) par des régions de liaison (47).

5. Dispositif selon la revendication 4, dans lequel ledit élément d'ancrage est défini par une partie dudit cadre externe (34).

6. Dispositif selon l'une quelconque des revendications précédentes, dans lequel ladite électrode enfouie (28) est suspendue à distance au-dessus de la surface supérieure (22a) du substrat (22), une cavité enfouie (54) étant disposée entre ladite surface supérieure (22a) et ladite électrode enfouie (28).

7. Dispositif selon la revendication 6, dans lequel ladite électrode enfouie (28) est supportée dans sa position suspendue au-dessus de la cavité enfouie (54) par un cadre interne sus-jacent (56), disposé dans la couche structurelle (30) ; dans lequel ledit cadre interne (56) est découplé de manière élastique dudit substrat (22) par au moins un élément de suspension élastique respectif (58) ayant une première extrémité respective accouplée au cadre interne (56) et une deuxième extrémité accouplée de façon fixe au substrat (22).

8. Dispositif selon la revendication 7, dans lequel la deuxième extrémité dudit élément de suspension élastique respectif (58) est connectée à un élément d'ancrage respectif (59) disposé dans la couche structurelle (30) et accouplé de façon fixe audit substrat (22) par un élément conducteur respectif (26), configuré pour la connexion électrique avec ladite électrode enfouie (28).

9. Dispositif selon l'une quelconque des revendications précédentes, comprenant en outre un boîtier (6) comportant une couche de support (12), ayant une surface avant respective (12a), à laquelle ladite structure de détection (14) est accouplée, et une surface arrière respective (12b), à l'opposé de la surface avant respective (12a), qui définit une surface extérieure principale (6b) du boîtier (6) ; ledit boîtier (6) comprenant en outre un revêtement (18) qui recouvre et enrobe latéralement la structure de détection (14) pour définir une partie de surfaces latérales extérieures (6c) et une partie d'une autre surface extérieure principale (6a) du boîtier (6), une partie de ladite autre surface extérieure principale (6a) étant définie par la deuxième surface principale (46b) du capot (46) de ladite structure de détection (14).

10. Dispositif selon la revendication 9, comprenant en outre un circuit électronique (15), associé à la structure de détection (14), fourni dans une matrice respective de matériau semiconducteur, accouplé à ladite couche de support (12) disposée le long de ladite structure de détection (14).

11. Elément d'interface utilisateur (4) pour appareil électronique portable ou prêt-à-porter (1), comprenant : le dispositif de bouton microélectromécanique (5) selon l'une quelconque des revendications précédentes ; et, de plus, une partie déformable (3) d'une enveloppe (2) de l'appareil électronique (1), accouplée mécaniquement à la deuxième surface principale (46b) du capot (46) dudit dispositif de bouton microélectromécanique (5).

12. Elément d'interface utilisateur selon la revendication 11, dans lequel ladite pression est le résultat d'une déformation de la partie déformable (3) de l'enveloppe (2) de l'appareil électronique (1), due à une force extérieure (Fₑₓₜ) appliquée sur ladite partie déformable (3) depuis l'extérieur de ladite enveloppe (2) pour réaliser l'actionnement dudit dispositif de bouton microélectromécanique (5).

13. Appareil électronique portable ou prêt-à-porter (1), comprenant l'élément d'interface utilisateur (4) selon la revendication 11 ou 12, qui définit un bouton physique.

14. Appareil électronique selon la revendication 13, comprenant : une chambre (7) à l'intérieur de l'enveloppe (2), dans laquelle est placé ledit dispositif de bouton microélectromécanique (5) ; un support souple (9) intégrant des chemins de connexion électrique (9') contenus dans la chambre (7) et auxquels ledit dispositif de bouton microélectromécanique (5) est accouplé de façon électrique et mécanique ; et une carte de circuit imprimé (11), placée dans la chambre (7) et fixée à l'enveloppe (2) ; dans lequel ledit support souple (9) est couplé à ladite carte de circuit imprimé (11) par un élément de connexion (10).

15. Procédé de fabrication d'un dispositif de bouton microélectromécanique (5) comprenant les étapes suivantes :
fournir un substrat (22) en matériau semiconducteur ayant une surface avant (22a) et une surface arrière (22b), qui ont une extension dans un plan horizontal (xy) et qui sont à l'opposé l'une de l'autre le long d'un axe vertical (z), orthogonal au plan horizontal (xy) ;
former une électrode enfouie (28), par la définition d'une couche conductrice (25) sur le substrat (22) ;
former une électrode mobile (32), par la définition d'une couche structurelle (30) recouvrant le substrat (22), suspendue de manière élastique au-dessus de l'électrode enfouie (28) avec une distance de séparation afin de former un condensateur de détection (C_{d}) ; et
accoupler un capot (46) sur la couche structurelle (30), ayant une première surface principale (46a) en face de la couche structurelle (30) et une deuxième surface principale (46b), à l'opposé de la première surface principale (46a) le long de l'axe vertical (z), qui est conçue pour être accouplée de façon mécanique à une partie déformable (3) d'une enveloppe (2) d'un appareil électronique (1) du type portable ou prêt-à-porter ;
comprenant en outre la formation d'une partie d'actionnement (48) dudit capot (46), au niveau de ladite première surface principale (46a), ladite partie d'actionnement (48) étant placée sur l'électrode mobile (32) et configurée de manière à provoquer, en présence d'une pression appliquée sur la deuxième surface principale (46b), une déviation de l'électrode mobile (32) et son rapprochement de l'électrode enfouie (28), avec une variation capacitive consécutive du condensateur de détection (C_{d}), ladite variation capacitive indiquant un actionnement dudit dispositif de bouton microélectromécanique (5),
comprenant en outre la formation d'un élément de suspension élastique (36), par la définition de ladite couche structurelle (30), ayant une première extrémité accouplée à l'électrode mobile (32) et une deuxième extrémité accouplée de manière fixe au substrat (22), ledit élément de suspension élastique (36) étant configuré pour supporter ladite électrode mobile (32) suspendue en porte-à-faux au-dessus de l'électrode enfouie (28) et pour permettre la déviation de celle-ci vers l'électrode enfouie (28) sous-jacente,
**caractérisé en ce que** la formation de l'élément de suspension élastique (36) comprend la formation de ladite deuxième extrémité connectée à un élément d'ancrage (34, 37) placé dans la couche structurelle (30) et accouplé de manière fixe audit substrat (22) par un élément conducteur (26), configuré pour la connexion électrique avec ladite électrode mobile (32).

16. Procédé selon la revendication 15, dans lequel la formation de ladite électrode enfouie (28) comprend la formation de ladite électrode enfouie (28) suspendue à distance au-dessus de la surface supérieure (22a) du substrat (22), une cavité enfouie (54) étant disposée entre ladite surface supérieure (22a) et ladite électrode enfouie (28) ; comprenant en outre la formation, par la définition de ladite couche structurelle (30), d'un cadre interne (56), qui supporte, dans sa position suspendue au-dessus de la cavité enfouie (54), l'électrode enfouie (28) sous-jacente ; et un élément de suspension élastique respectif (58), qui a une première extrémité respective accouplée au cadre interne (56) et une deuxième extrémité accouplée de façon fixe au substrat (22).

17. Procédé selon la revendication 15 ou 16, comprenant en outre la formation d'un premier évidement (50a) et un deuxième évidement (50b), qui s'étendent dans le capot (46), dans la direction de l'axe vertical (z), sur des côtés opposés de ladite partie d'actionnement (48).
